# EUROPEAN PATENT SPECIFICATION

(11) **EP 4 345 433 B1**
(45) Date of publication and mention of the grant of the patent: **25.02.2026**
(21) Application number: 22199209.2
(22) Date of filing: 30.09.2022
(51) Int. Cl.: G01K 1/16, G01K 13/00, G01R 31/12, H02B 13/065

(54) **SWITCHGEAR DEVICE**
SCHALTGERÄT
DISPOSITIF DE COMMUTATION

(43) Date of publication of application: 03.04.2024
(73) Proprietor: Siemens Aktiengesellschaft, 80333 München (DE)
(72) Inventor: CHIKHALE, Ravindra, 403602 GOA, Goa (IN); SONAWANE, Mahesh, 410210 Navimumbai, Maharashtra (IN); UNADE, Mahadeo, 410210 Navi Mumbai, Maharashtra (IN)
(74) Representative: Patentanwaltskanzlei WILHELM & BECK

(56) References cited:
- CN-A- 102 121 962
- CN-A- 112 146 773

## Description

The present disclosure relates to a switchgear and more particularly condition monitoring of the switchgear such as monitoring of parameter(s) associated with the switchgear.

A switchgear also referred to as a switching device or a switchgear device is an apparatus used for controlling, regulating, and switching ON and OFF of an electrical circuit in an electrical power distribution network. The switchgear is typically placed in high, medium and low voltage areas for de-energizing substation equipment, for example, on both sides of a power transformer, before testing and maintenance and for clearing faults. For instance, when a fault occurs in the electrical power distribution network, heavy current flows through substation equipment due to which there is a risk that the equipment may get damaged, and the power flow may also get interrupted. Therefore, in order to protect the power lines, generators, transformers and other such equipment from damage, automatic protective devices, such as the switchgear devices, are utilized.

Typically, even the highly reliable and rugged switchgears are subject to wear and tear due to ageing. One of the most common failures is building up of heat at joints which leads to the increase in resistance and degradation of contacts and insulating components. Thermal failures such as these are most commonly visible in medium voltage distribution switchgears, where electrical currents may go upto a few thousand amperes.

To avoid failures and downtime, from an early stage, switchgears need constant monitoring of important parameters such as temperature and partial discharge.

According to IEC standard 60270 published on November 1st 2015, partial discharge refers to a localized electrical discharge that only partially bridges the insulation between conductors and which can or cannot occur adjacent to a conductor. Partial discharge also refers to a localized dielectric breakdown of a portion of an electrical insulation system under high voltage stress, which partially bridges the gap between two conductors having different electrical potential. Partial discharge may be internal and/or external depending on its place of occurrence. Partial discharge indicate that locally the electric insulation cannot withstand the electric field stress applied. In general partial discharge occurs in areas of the insulation or on the surface of the insulation that is subjected to higher local electric field stress concentrations, such as in a cavity in a solid dielectric, a sharp protrusion, or in low density regions of a liquid dielectric. Partial discharge initiates once electric field is high enough or mean-free path is short enough, to cause impact ionization to create a streamer, also known as an electron avalanche.

Conventionally, temperature sensors are mounted on the conducting components of a switchgear for monitoring the temperatures. Generally, temperature sensors such as thermocouples, resistance temperature detector (RTD) sensors, digital temperature sensors, etc., are not suited for the required dielectric withstand capacity of medium voltage switchgears. For example, in a 24 kV system, the required dielectric withstand level is 50 kV power frequency and 125 kV impulse voltage which is way higher for typical thermal sensors. Due to this mounting of temperature sensors directly on high-voltage parts for temperature monitoring is not feasible.

Presently, external and embedded sensors are being used to address the aformentioned problem. In case of external sensing, passive wireless sensors are employed which utilize surface acoustic wave (SAW) technology or radio-frequency identification (RFID) technology for sensing. Both technologies make sensors wireless, so it is possible to mount sensors directly on conducting parts of the switchgear like busbar joints, contacts while meeting dielectric withstand capacity of switchgear. However, this calls for an elaborate placement of sensors and also requires additional costly hardware to collect signals from each of the wireless sensors. Moreover, it also raises performance concerns during harsh EMC/EMI and insulation tests. Furthermore, switchgear interiors are lined with conducting metallic plates that may result in deflection of radio signals of these wireless sensors.

In case of embedded sensors, temperature sensors are directly embedded in cast resin bushing of the switchgear by maintaining dielectrically suitable gap from a live/ hot conductor. Such temperature sensors are shielded with respect to electric field to meet the dielectric withstand capacity. Heat is transferred from hot point or hot spots, for example, busbar joints with cables to the temperature sensor through a cast resin gap. A wired tap is taken from this sensor and is connected to a temperature monitoring system. However, cast resin having thermal conductivity in range of 0.8-0.9 W/mK, it is not a good conductor of heat which leads to a significant time delay in temperature transfer and therefore, temperature gap from the hot point to the sensor. Moreover, the relation between the actual temperature and measured temperature is nonlinear due to heat dissipation into the cast resin between the sensor and the hot point. This leads to a significant difference in the actual temperature of the hot point and the temperature measured by the sensor.

CN 112 146 773 discloses a sensor assistance device connectable to a current path in a switching device for facilitating sensing of a temperature comprising a temperature tap, a composite conductor having a first conducting member and a ceramic member, wherein the ceramic member is operably connected to the temperature tap

CN 102 121 962 discloses a sensor assistance device connectable to a current path in a switching device for facilitating sensing of a partial discharge comprising a partial discharge tap, a composite conductor having a first conducting member and a ceramic member, wherein the first conducting member is operably connected to the partial discharge tap and a ceramic member rigidly connected to and positioned between the first conducting member and a second conducting member. Accordingly, it is an object of the present disclosure to provide a sensor assistance device and a switch device that addresses the aforementioned problems associated with condition monitoring, and specifically temperature monitoring and partial discharge monitoring, without increasing the complexity and costs associated with the device.

The object is met by the independent claim. Preferred embodiments are disclosed in the subclaims.

The switchgear provided herein is a medium voltage switchgear or a low voltage switchgear. The switchgear is, for example, an air insulated switchgear or a gas insulated switchgear. The parameters comprise a temperature and a partial discharge associated with the conducting component(s). As referred to herein, "partial discharge" is a derived parameter of a partial discharge current that flows via the composite conductor. The conducting components lie in the current path. The conducting components comprise, for example, a circuit breaker, a bus bar joint, a cable terminal, etc. The circuit breaker is adapted to open/interrupt the current path and adapted to close the current path subject to electrical faults and/or maintenance activities pertaining to the switchgear.

The switchgear, also referred to as the switching device, disclosed herein achieves the aforementioned object via a sensor assistance device having a composite conductor connectable to a current path in the switching device, for facilitating sensing of parameter(s) associated with conducting component(s) of the switching device. The composite conductor used herein refers to an arrangement having a member that is thermally and electrically conductive connected to a member that is thermally conductive and electrically non-conductive.

The composite conductor disclosed herein comprises a first conducting member and a ceramic member. The first conducting member is operably connected to a tap that facilitates sensing of the parameter(s) when connected to a sensor. The tap in turn is connected to a sensor system that receives an input via the tap and provides a value corresponding to the input. The tap includes a temperature tap and a partial discharge tap. The partial discharge tap may be connected to a partial discharge measurement system.

The first conducting member conducts electrically and thermally and comprises one or more conducting metals comprising, for example, aluminium, copper, and/or an alloy thereof. Alternatively, the first conducting member includes a conductive coating.

The ceramic member conducts thermally. Advantageously, the ceramic member does not conduct electrically. This allows the composite conductor to isolate potential and therefore, prevent any harm to the parameter measurement systems connectable to the first conducting member via the tap(s). The ceramic member is made of one or more of aluminum oxide and aluminum nitride.

The thermal conductivity of aluminium nitride is available in the range of 100 to 260 W/mK and that of aluminium oxide is available in the range of 28 to 35 W/mK. The selection of the aforementioned materials depends on how much heat transfer is required from the current path, that is, the hotspot to the first conducting member of the composite conductor for effective and accurate sensing of temperature as a parameter. The dielectric strength of both materials is in the range of 17 - 20 kV/mm. Ceramic as a material has good thermal conductivity and high dielectric strength and therefore, it acts as a conductor to heat and an insulator to electricity.

The sensor assistance device disclosed herein is connectable to a current path and comprises a second conducting member connectable to the current path, that is, positionable in the current path. For example, the second conducting member is operably attachable via a fastener to a live busbar joint that is a potential hotspot. The second conducting member conducts thermally and electrically and is made of one or more of conducting metals, including, for example, copper, aluminium, and/or an alloy thereof. Alternatively, the second conducting member includes a conductive coating.

According to one aspect, the ceramic member of the composite conductor is rigidly connected to and positioned between the first conducting member and an integrated conducting member of the switching device, wherein the integrated conducting member lies in the current path. The integrated conducting member is, for example, a bushing conductor connected to a circuit breaker of the switching device wherein the bushing conductor lies in the current path created between the circuit breaker and the cable terminal, thus, lying in a potential hotspot. According to this embodiment, the composite conductor is connected with the bushing conductor such that the ceramic member is sandwiched between the first conducting member and the integrated conducting member, that is, the bushing conductor, and the composite conductor and the bushing conductor are encapsulated in the bushing connected to the circuit breaker.

According to another aspect, the ceramic member of the composite conductor is rigidly connected to and positioned between the first conducting member and a second conducting member of the sensor assistance device. The sensor assistance device disclosed herein comprises an encapsulation housing therewithin, that is, at least partially accommodating therewithin, the composite conductor and the second conducting member, according to this aspect. The encapsulation comprises insulating material(s), for example, resin or epoxy.

The rigid connection between the ceramic member and the conducting members, according to various aspects, that is either a second conducting member of the sensor assistance device or an integrated conducting member of the switchgear, involves, for example, a moulded connection, a press fit connection, a fixed connection, etc. Advantageously, the conducting members are configured to have a collar at one of each of their ends such that the ceramic member can be positioned and securely held in these collars. Moreover, after positioning the cermaic member between the collars, the three members namely the conducting members and the ceramic member sandwiched therebetween are held in position. An epoxy material or a resin material is poured into a mould therearound such that the three members are at least partially encapsulated by the insualting material forming an encapsulation. Advantageously, the rigid connection is performed so as to allow maximum heat transfer from the second conducting member or the integrated conducting member to the first conducting member.

Physical dimensions comprising, for example, a length and a cross-section or thickness of the three members are selected based on factors such as temperature rating, voltage rating, dielectric withstand capacity requirement, etc. For example, higher the dielectric withstand capacity requirement, larger is the thickness and length or height of the members. Also, the cross-section/thickness and length/height of the ceramic member in particular is selected as per required capacitance vlue of the coupling capacitor used for sensing the partial discharge.

Also disclosed herein is use of the aforementioned sensor assistance device in sensing parameter(s), that is, temperature and partial discharge associated with the conducting components of the switching device.

The ceramic member of the composite conductor of the sensor assistance device, when sandwiched between the conducting members according to various aforementioned aspects, and casted in an encapsulation, makes the sensor assistance device act as an insulator such that one end of this insulator, that is, the second conducting member of the sensor assistance device or the integrated conducting member of the switching device, according to various aspects, is mounted on a hotspot typically formed in the current path, for example, a live busbar joint. With this, the conducting member of the insulator transfers heat to the ceramic member. Further, the ceramic member transfers heat to the other end, that is, the first conducting member while providing insulation against the live potential of the busbar joint. Thus, the sensor assistance device enables heat to be carried out from the hot spot from its one end to its another end without potential, where parameter such as temperature can be measured. The sensor assistance device enables normal temperature sensors such as thermocouples, RTD sensors, digital temperature sensors, etc., to be directly mounted on thereon. The ceramic member provides di-electric withstand capacity to these temperature sensors thus enabling effective monitoring of temperature from live potential busbar joints or conductors without dielectric failure. The sensor assistance device thus allows these directly mounted temperature sensors to be connected to temperature monitoring/data loggers without costly hardware like antenna/receivers, etc.

In addition to the temperature monitoring same insulator, that is, the sensor assistance device, can be used as a coupling capacitor for partial discharge measurement or capacitive voltage detection (CVD) system. As mentioned above, ceramic is having very good dielectric properties so sandwiched ceramic between the two conductors acts as a capacitor along with cast resin. When partials discharge occurs, partial discharge current flows towards earth via this capacitance formed by the ceramic member of the composite conductor of the sensor assistance device.

As partial discharge currents have very high frequency, the ceramic member acting as a coupling capacitor provides a low impedance path thus allowing the partial discharge current to flow therethrough and thereby allowing partial discharge as a condition to be monitored with help of external partial discharge measurement systems when connected to the first conducting member via the partial discharge tap. The capacitance value of the ceramic member can be designed by selecting suitable diameter and height of the ceramic member. Generally, the capacitance value is in the range of 5 to 100 pF.

The aforementioned composite conductor, the sensor assistance device, the switching device and the use thereof in sensing parameter(s) associated with conducting components of the switching device pose several advantages when compared to the conventional parameter sensing and condition monitoring techniques, for example, the sandwiched ceramic member inside the encapsulation enables direct mounting of normal temperature sensors, as ceramic provides dielectric withstand capacity suitable for a medium voltage switchgear's live joint/contact. Moreover, linear relation between the actual temperature at a hotspot and measured temperature at the hotspot is achieved as ceramic is a good conductor of heat. Furthermore, the sandwiched ceramic member ensures low time delay in temperature transfer from the hotspot to a point of measurement of the parameter. Furthermore, a single device facilitates monitoring of temperature and partial discharge thus, eliminating need for additional costly hardware.

The above-mentioned and other features of the present disclosure will now be addressed with reference to the accompanying drawings of the present disclosure. The illustrated embodiments are intended to illustrate, but not limit the invention.

The present invention is further described hereinafter with reference to illustrated embodiments shown in the accompanying drawings, in which:
- FIG 1: illustrates a sensor assistance device for sensing temperature and partial discharge associated with hot spot(s) within a switchgear, according to an embodiment of the present disclosure;
- FIG 2: illustrates a bushing of a switchgear, having a bushing conductor rigidly connected to a ceramic member and a conducting member of a composite conductor of the sensor assistance device shown in FIG 1, for sensing temperature and partial discharge associated with a circuit breaker and a cable terminal, according to an embodiment of the present disclosure; and
- FIG 3: illustrates the switchgear having the composite conductor of the sensor assistance device, shown in FIG 2, according to an embodiment of the present disclosure.

Various embodiments are described with reference to the drawings, wherein like reference numerals are used to refer like elements throughout. In the following description, for the purpose of explanation, numerous specific details are set forth in order to provide thorough understanding of one or more embodiments. It may be evident that such embodiments may be practiced without these specific details.

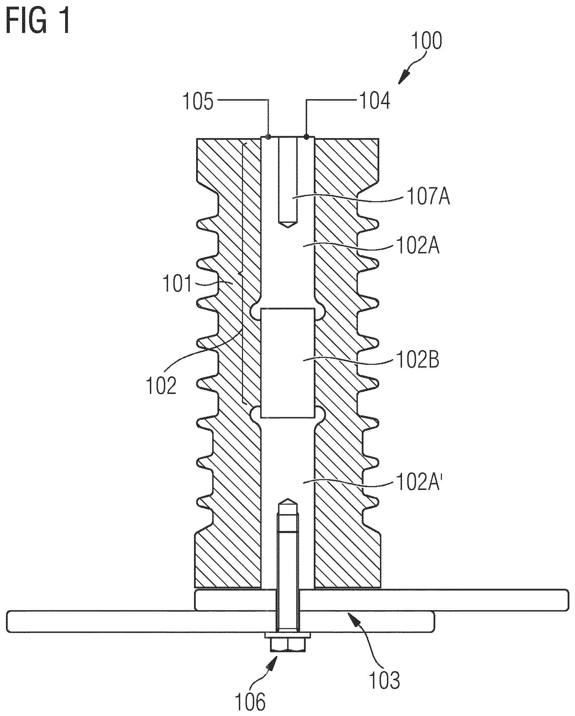

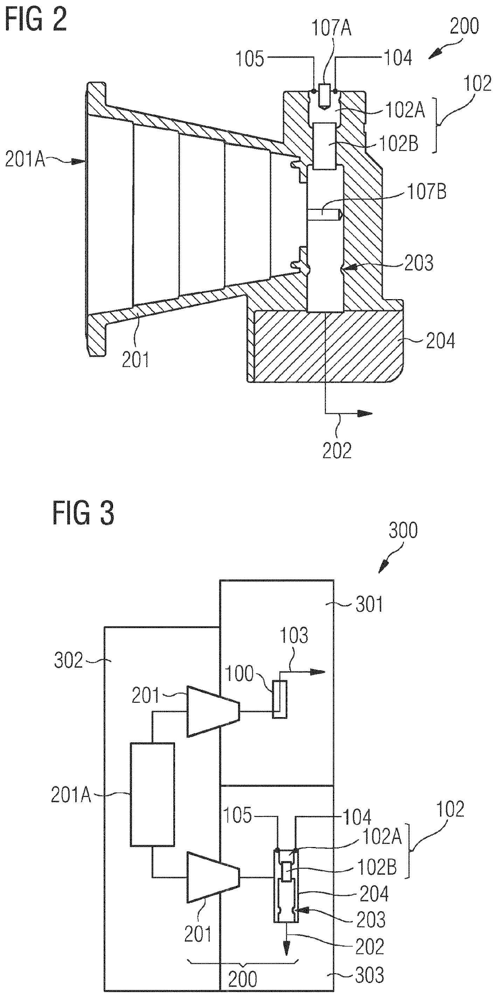

FIG 1 illustrates a sensor assistance device 100 for sensing temperature and partial discharge associated with hot spot(s) within a switchgear, according to an embodiment of the present disclosure. The sensor assistance device 100 comprises an encapsulation such as a bushing 101. The bushing 101 may be a cast resin or an epoxy bushing. The bushing at least partially accommodates therewithin a first conducting member 102A, a ceramic member 102B, and a second conducting member 102A' rigidly connected with one another, for example, via moulding and or press fitting. As shown in FIG 1, the ceramic member 102B is sandwiched between the two conducting members 102A and 102A'. The first conducting member 102A and the ceramic member 102B form a composite conductor 102 which can be connected to the second conducting member 102A' as shown in FIG 1 or to an integrated conducting member of a switching device such as a switchgear, as described in detailed description of FIG 2 and FIG 3.

The sensor assistance device 100 is positioned directly or in close proximity of a hotspot (not shown) inside a switchgear, that is, a conducting component of the switchgear which is a potential hotspot thereby requiring thermal monitoring. Moreover, the sensor assistance device 100 is positioned with respect to the aforementioned hotspot such that the second conducting member 102A' is at a high potential, that is, in close proximity of a high potential area of the hotspot. As shown in FIG 1, the hotspot is formed, for example, around a fastening member 106 of a live busbar joint 103 on which the sensor assistance device 100 is positioned.

A temperature tap 104 and a partial discharge tap 105 are operably connected to the conducting member 102A, for example, via a conducting metallic fastener 107A such as a screw. The ceramic member 102B is made of a thermally conducting material as opposed to the conducting members 102A and 102A' which are made of electrically and thermally conducting materials. Thus, the ceramic member 102B acts as an insulator and limits transfer of high potential from the second conducting member 102A', that is in contact with the hotspot, to the first conducting member 102A thus, protecting the temperature and the partial discharge taps 104 and 105 respectively from the high potential. However, the ceramic member 102B being thermally conducting allows transfer of heat from the hotspot via the second conducting member 102A' to the first conducting member 102A thereby, enabling accurate sensing of temperature. The taps 104 and 105 are further connected to a temperature sensing system (not shown) and a partial discharge monitoring system (not shown). The ceramic member 102B sandwiched between the conducting members 102A and 102A' acts as a coupling capacitor thus, allowing measurement of partial discharge or capacitive voltage detection (CVD).

FIG 2 illustrates a bushing 200 of a switchgear, having a bushing conductor 203 rigidly connected to a ceramic member 102B and a conducting member 102A of a composite conductor 102 of the sensor assistance device 100 shown in FIG 1, for sensing temperature and partial discharge associated with a circuit breaker 201A and a cable terminal 202, according to an embodiment of the present disclosure. It would be understood by a person skilled in the art that the cable terminal 202 and the circuit breaker 201A have been represented with help of arrows so as to indicate a current path, that is, a connection going towards the cable terminal 202 and a current path, that is, a connection coming from the circuit breaker 201A.

FIG 2 shows an embodiment of the sensor assistance device 100 wherein an existing conducting member, that is, the bushing conductor 203, that is, an integrated conducting member is used along with the first conducting member 102A of the composite conductor 102 for sandwiching the ceramic member 102B of the composite conductor 102.

As shown in FIG 2, the bushing 200 has a horizontal section 201 and a vertical section 204. The horizontal section 201 houses therewithin the connections coming from the circuit breaker 201A and terminating, for example, into a conducting metallic fastener 107B connected to the bushing conductor 203 which in turn is further connected to the cable terminal 202. Thus, there exists a potential hotspot (not shown) around the conducting metallic fastener 107B.

Thus, the bushing conductor 203 is positioned in proximity of the high potential hotspot area surrounding the conducting metallic fastener 107B and the temperature and partial discharge taps 104 and 105 respectively are operably connected to the first conducting member 102A via a conducting metallic fastener 107A.

FIG 3 illustrates the switchgear 300 having the composite conductor 102 of the sensor assistance device 100, shown in FIG 2, according to an embodiment of the present disclosure.

The composite conductor 102 is connected to an integrated conducting member 203, that is, a bushing conductor 203 as shown in FIG 2. The switchgear 300, is for example a medium voltage switchgear, comprising a busbar compartment 301, a breaker compartment 302 and a cable compartment 303. The switchgear 300 also has a low voltage compartment (not shown) that allows access to the switchgear 300.

The busbar compartment 301 typically houses therewithin a central busbar system having three busbars, one for each phase of a three-phase power supply. Each busbar 103 is connected to a circuit breaker 201A housed inside the breaker compartment 302, via a bushing 200 positioned partly inside the breaker compartment 302 and the busbar compartment 301. The circuit breaker 201A is further connected to a cable terminal 202 housed inside the cable compartment 303 via a horizontal section 201 and a vertical section 204 of another bushing 200 positioned partly inside the breaker compartment 302 and the cable compartment 303. The vertical section 204 houses therewithin a bushing conductor 203 into which the connections from the circuit breaker 201A are terminated. Temperature and partial discharge taps 104 and 105 respectively are connected to the conducting member 102A as described in the detailed description of FIG 2.

Similarly, a sensor assistance device 100 may be positioned in the busbar compartment 301 in the current path created between the busbar 103 and the circuit breaker 201A or at a busbar joint as shown in FIG 1.

While the present invention has been described in detail with reference to certain embodiments, it should be appreciated that the present invention is not limited to those embodiments. In view of the present disclosure, many modifications and variations would be present themselves, to those skilled in the art without departing from the scope of the various embodiments of the present invention, as described herein. The scope of the present invention is, therefore, indicated by the following claims rather than by the foregoing description.

## Claims

1. A sensor assistance device (100) connectable to a current path in a switching device (300), for facilitating sensing of a temperature and a partial discharge associated with one or more conducting components (103, 201A, 202) of the switching device (300), wherein the conducting components (103, 201A, 202) are placed in the current path, comprising :
- a temperature tap (104) and a partial discharge tap (105);
- a composite conductor (102) having a first conducting member (102A) and a ceramic member (102B),
wherein the first conducting member (102A) is operably connected to the temperature tap (104) and the partial discharge tap (105) and
wherein the ceramic member (102B) is rigidly connected tc and positioned between the first conducting member (102A) and a second conducting member (102A') or an integrated conducting member (203) of the switching device (300), wherein the second conducting member (102A') or the integrated conducting member (203) is mounted on a hotspot formed in the current path.

2. The composite conductor (102) according to claim 1,
wherein the first conducting member (102A) is configured to conduct electrically and thermally.

3. The composite conductor (102) according to claim 1 or 2, wherein the first conducting member (102A) comprises one or more conducting metals.

4. The composite conductor (102) according to any of claims 1 to 3, wherein the ceramic member (102B) is configured to conduct thermally, and comprises one or more of aluminum oxide and aluminum nitride.

5. A switching device (200, 300) comprising:
- one or more conducting components (103, 201A, 202) positioned in a current path; and
- a sensor assistance device (100) according to claims 1-4.

6. The switching device (200, 300) according to claim 5 is a switchgear.

## Patentansprüche

1. Sensorunterstützungsvorrichtung (100), die mit einem Strompfad in einer Schaltvorrichtung (300) verbindbar ist, um ein Erfassen einer Temperatur und einer Teilentladung zu ermöglichen, die mit einer oder mehreren leitenden Komponenten (103, 201A, 202) der Schaltvorrichtung (300) assoziiert sind, wobei die leitenden Komponenten (103, 201A, 202) in dem Strompfad angeordnet sind, umfassend:
- einen Temperaturabzweig (104) und einen Teilentladungsabzweig (105);
- einen Verbundleiter (102) mit einem ersten leitenden Element (102A) und einem keramischen Element (102B),
wobei das erste leitende Element (102A) mit dem Temperaturabzweig (104) und dem Teilentladungsabzweig (105) wirkverbunden ist und
wobei das keramische Element (102B) starr mit dem ersten leitenden Element (102A) und einem zweiten leitenden Element (102A') oder einem integrierten leitenden Element (203) der Schaltvorrichtung (300) verbunden und zwischen diesen positioniert ist, wobei das zweite leitende Element (102A') oder das integrierte leitende Element (203) auf einem in dem Strompfad gebildeten Heißpunkt montiert ist.

2. Verbundleiter (102) nach Anspruch 1, wobei das erste leitende Element (102A) dazu ausgestaltet ist, elektrisch und thermisch zu leiten.

3. Verbundleiter (102) nach Anspruch 1 oder 2, wobei das erste leitende Element (102A) ein oder mehrere leitende Metalle umfasst.

4. Verbundleiter (102) nach einem der Ansprüche 1 bis 3, wobei das keramische Element (102B) dazu ausgestaltet ist, thermisch zu leiten, und eines oder mehrere von Aluminiumoxid und Aluminiumnitrid umfasst.

5. Schaltvorrichtung (200, 300), die Folgendes umfasst:
- eine oder mehrere leitende Komponenten (103, 201A, 202), die in einem Strompfad positioniert sind; und
- eine Sensorunterstützungsvorrichtung (100) nach den Ansprüchen 1-4.

6. Schaltvorrichtung (200, 300) nach Anspruch 5, die eine Schaltanlage ist.

## Revendications

1. Dispositif d'assistance de capteur (100) pouvant être connecté à un trajet de courant dans un dispositif de commutation (300), pour faciliter la détection d'une température et d'une décharge partielle associées à un ou plusieurs composants conducteurs (103, 201A, 202) du dispositif de commutation (300), dans lequel les composants conducteurs (103, 201A, 202) sont placés dans le trajet de courant, comprenant :
- une prise de température (104) et une prise de décharge partielle (105) ;
- un conducteur composite (102) ayant un premier élément conducteur (102A) et un élément en céramique (102B),
dans lequel le premier élément conducteur (102A) est connecté de manière fonctionnelle à la prise de température (104) et à la prise de décharge partielle (105) et
dans lequel l'élément céramique (102B) est relié rigidement au premier élément conducteur (102A) et à un second élément conducteur (102A') ou à un élément conducteur intégré (203) du dispositif de commutation (300) et positionné entre ceux-ci, dans lequel le second élément conducteur (102A') ou l'élément conducteur intégré (203) est monté sur un point chaud formé dans le trajet de courant.

2. Conducteur composite (102) selon la revendication 1, dans lequel le premier élément conducteur (102A) est configuré pour conduire l'électricité et la chaleur.

3. Conducteur composite (102) selon la revendication 1 ou 2, dans lequel le premier élément conducteur (102A) comprend un ou plusieurs métaux conducteurs.

4. Conducteur composite (102) selon l'une quelconque des revendications 1 à 3, dans lequel l'élément céramique (102B) est configuré pour conduire la chaleur, et comprend de l'oxyde d'aluminium et/ou du nitrure d'aluminium.

5. Dispositif de commutation (200, 300) comprenant :
- un ou plusieurs composants conducteurs (103, 201A, 202) positionnés dans un trajet de courant ; et
- un dispositif d'assistance de capteur (100) selon les revendications 1 à 4.

6. Dispositif de commutation (200, 300) selon la revendication 5 qui est un appareillage de commutation.
